# FASCICULE DE BREVET EUROPEEN

(11) **EP 3 069 155 B1**
(45) Date de publication et mention de la délivrance du brevet: **30.08.2017**
(21) Numéro de dépôt: 14798874.5
(22) Date de dépôt: 14.11.2014
(51) Int. Cl.: G01R 31/40, H01L 31/18

(54) **PROCEDE DE TEST D'UN MODULE PHOTOVOLTAIQUE A CONCENTRATION**
VERFAHREN ZUM TESTEN EINES KONZENTRIERTEN PHOTOVOLTAISCHEN MODULS
METHOD FOR TESTING A CONCENTRATED PHOTOVOLTAIC MODULE

(30) Priorité: 14.11.2013 FR 1361139
(43) Date de publication de la demande: 21.09.2016
(73) Titulaire: Saint-Augustin Canada Electric Inc., Saint-Augustin de Desmaures, Québec G3A 1S5 (CA)
(72) Inventeur: BLANCHARD, Rémi, F-38000 Grenoble (FR); GASTALDO, Philippe, F-38530 Pontcharra (FR)
(74) Mandataire: Grünecker Patent- und Rechtsanwälte PartG mbB
(86) Numéro de dépôt international: PCT/EP2014/074632
(87) Numéro de publication internationale: WO 2015/071423

(56) Documents cités:
- WO-A1-2010/003115

## Description

### DOMAINE DE L'INVENTION

La présente invention concerne un procédé et un dispositif de test d'un module photovoltaïque à concentration.

### ARRIERE PLAN DE L'INVENTION

Un module photovoltaïque à concentration (CPV, acronyme du terme anglo-saxon « Concentration PhotoVoltaic ») comprend essentiellement une cellule photovoltaïque (par exemple multi-jonctions) et un concentrateur destiné à concentrer le rayonnement solaire vers ladite cellule.

Dans le cas d'une cellule multi-jonctions, les différentes jonctions sont agencées en série, chacune des jonctions étant adaptée à une bande spectrale spécifique du spectre solaire. Le document WO2010003115A décrit des modules photovoltaïques. Les cellules multi-jonctions, qui sont de plus petites dimensions que les cellules solaires en silicium conventionnelles, présentent l'avantage d'offrir un meilleur rendement, mais nécessitent pour fonctionner une intensité lumineuse plus élevée.

Dans un module CPV, les cellules sont associées à un concentrateur, par exemple une lentille de Fresnel, qui concentre le rayonnement solaire vers la cellule.

En outre, les modules photovoltaïque sont destinés à être montés sur un système suiveur de soleil (également appelé « tracker » dans la terminologie anglo-saxonne) de sorte à orienter de manière optimale le module en fonction de la trajectoire du soleil pour que les concentrateurs focalisent les rayons du soleil sur les cellules.

Lors de la fabrication de tels modules photovoltaïques, il est habituel de vérifier le fonctionnement et les performances de chaque module, en vue de détecter une éventuelle défaillance de l'une des jonctions, des défauts de qualité ou de positionnement des concentrateurs, ou toute autre anomalie du module avant que celui-ci ne soit expédié.

Il est fréquent que les modules soient combinés en étant montés totalement ou partiellement en série. Dans ce cas, les performances du système global seront limitées par l'élément le plus faible. Il peut donc s'avérer utile de sélectionner les modules devant être combinés afin qu'ils soient homogènes en réponse. Dans cet objectif, il est important de pouvoir mesurer la performance de ce module.

A cet effet, il est connu de simuler l'éclairement du soleil au moyen d'un dispositif d'éclairement généralement appelé « flasher », qui génère un faisceau lumineux présentant une irradiance, une distribution spectrale de puissance et une divergence angulaire proches de celles du soleil. Ces caractéristiques devront être conformes sur l'ensemble de la surface du module à tester.

Les modules CPV présents actuellement sur le marché présentent des dimensions relativement faibles (de l'ordre de 0,5 à 1,5 m²). Il existe des dispositifs d'éclairement qui permettent de simuler l'éclairement solaire sur un module de ce type.

La société Soitec a mis sur le marché des modules solaires de grandes dimensions, présentant une surface de plusieurs m², comprenant plusieurs modules CPV solidarisés par un châssis unique.

Ainsi, par exemple, un module de 8 m² peut être formé de deux rangées de six sous-modules, qui peuvent éventuellement être connectés en série.

Il se pose donc le problème de pouvoir tester un module de grandes dimensions. En effet, les sous-modules étant connectés totalement ou partiellement en série et leur intégrité mécanique étant assurée par un châssis unique, ils ne peuvent être testés indépendamment.

D'autre part, il est important de garantir le fonctionnement de l'ensemble assemblé avant qu'il ne soit installé.

Il est donc nécessaire de pouvoir vérifier les performances du module complet, en simulant un éclairement qui soit le plus proche du rayonnement solaire.

A cet égard, les contraintes que doit respecter le dispositif d'éclairement sont les suivantes :
- une irradiance comparable à celle produite par le soleil au niveau du sol, c'est-à-dire de l'ordre de 1 kW/m²,
- la reproduction du spectre solaire complet, de l'ultraviolet à l'infrarouge, en respectant les densités spectrales,
- une divergence angulaire proche de celle de la lumière solaire, c'est-à-dire de 0,5° (± 0,25°),
- une grande uniformité spatiale de l'irradiance (l'objectif étant une inhomogénéité de l'irradiance inférieure ou égale à 5%).

Les dispositifs d'éclairement connus ne répondent pas à ces exigences pour un module de grandes dimensions.

En effet, ces dispositifs offrent soit un champ plus réduit, soit des caractéristiques (notamment la divergence angulaire) trop éloignées de celles du soleil.

De telles caractéristiques sur des champs étendus de l'ordre du mètre carré à quelques mètres carrés avec une source lumineuse unique ne sont possibles à reproduire que sur des durées très courtes, avec des lampes à éclat (également dites lampes flash).

En effet, la puissance nécessaire pour obtenir une irradiance de l'ordre de 1 kW/m² sur une surface de l'ordre du m² serait trop importante pour être maintenue en continu (la consommation d'énergie serait alors très élevée et l'échauffement du système conséquent).

Les lampes à éclat sont généralement utilisées dans ce type de dispositif d'éclairement car elles permettent d'atteindre une intensité suffisante pour tester les modules photovoltaïques.

Une autre contrainte à prendre en compte pour concevoir le dispositif d'éclairement est la compacité de l'installation de test.

Ainsi, il n'est pas envisageable de placer une source lumineuse loin du module pour obtenir une faible divergence angulaire car, compte tenu de la surface du module, cela impliquerait une distance de plusieurs dizaines de mètres, non compatible avec une installation industrielle.

Il pourrait être envisagé d'utiliser plusieurs dispositifs connus qui éclaireraient chacun une partie du module.

Cependant, se pose alors le problème de la synchronisation des sources lumineuses comprenant des lampes à éclat produisant les différents faisceaux.

En effet, les sources lumineuses produisent des impulsions lumineuses et la mesure des performances du module sont enregistrées pendant ces impulsions.

Pour que la mesure soit exploitable, il faut donc que les impulsions se produisent au même instant pour l'ensemble des sources lumineuses, c'est-à-dire que les sources soient synchronisées dans une plage de l'ordre de quelques centaines de µs.

Or, les lampes à éclat des sources lumineuses sont alimentées par des batteries de condensateurs.

Il existe donc un délai entre le déclenchement de la source et l'émission de l'impulsion, qui est supérieur à la plage de synchronisation visée.

Ce délai est variable d'une source à l'autre.

Il peut être dû à l'impédance du circuit électrique de déclenchement, ou aux délais dus aux différences d'horloges des cartes de déclenchement.

### BREVE DESCRIPTION DE L'INVENTION

Un but de l'invention est de concevoir un dispositif de test d'un module photovoltaïque à concentration de grandes dimensions comme décrit dans la revendication 9, qui respecte les contraintes mentionnées ci-dessus, et qui offre notamment une synchronisation précise des sources lumineuses. Conformément à l'invention, il est proposé un procédé de test d'un module photovoltaïque à concentration comme döcrit dans la revendication 1 comprenant une pluralité de sous-modules comportant chacun une pluralité d'ensembles d'une cellule photovoltaïque et d'un concentrateur agencé par rapport à la cellule pour concentrer vers ladite cellule un rayonnement arrivant en incidence normale, ledit procédé étant caractérisé en ce que :
- on envoie vers ledit module une pluralité de faisceaux lumineux quasi collimatés au moyen d'une pluralité de sources lumineuses couplées à des miroirs paraboliques respectifs, chaque source lumineuse comprenant une lampe adaptée pour émettre une impulsion lumineuse et un dispositif d'alimentation adapté pour alimenter électriquement ladite lampe, chaque source lumineuse présentant un délai d'allumage entre le déclenchement du dispositif d'alimentation et l'émission de l'impulsion par la lampe, ledit délai étant propre à chaque source lumineuse respective,
- on déclenche le dispositif d'alimentation de chaque lampe à un instant respectif déterminé en fonction du délai d'allumage de ladite lampe de sorte que les impulsions de l'ensemble des lampes soient émises simultanément et reçues simultanément par les modules, et
- on mesure la réponse du module pendant lesdites impulsions simultanées.

Par simultanéité des impulsions, on entend que les impulsions présentent un recouvrement en intensité lumineuse (leur caractéristique d'émission lumineuse) d'au moins 95%, de préférence d'au moins 98.5 %.

Par exemple, pour une durée de mesure de 1 ms, on fait en sorte que l'écart maximal entre les instants respectifs des impulsions de deux lampes soit inférieur ou égal à 50 µs, de préférence inférieur ou égal à 15 µs.

Par faisceau quasi collimaté, on entend dans le présent texte un faisceau dont la divergence est faible, typiquement inférieure à 1°. Dans la présente invention, afin de reproduire la divergence du soleil, le faisceau quasi collimaté a une divergence de +/-0,25°.

De manière connue en elle-même, chaque faisceau quasi collimaté est obtenu en plaçant l'orifice de chaque source lumineuse au foyer ou au voisinage du foyer du miroir parabolique auquel il est couplé, l'homme du métier étant en mesure de définir les caractéristiques dimensionnelles de l'orifice et du couple miroir-source pour obtenir un tel faisceau quasi-collimaté.

De manière avantageuse, on détermine au préalable le délai d'allumage de chaque lampe en mesurant l'instant de déclenchement du dispositif d'alimentation et l'instant de l'impulsion, le délai d'allumage étant déterminé comme étant égal à la différence entre l'instant de l'impulsion et l'instant de déclenchement.

Selon un mode de réalisation, lesdites mesures sont effectuées en remplaçant chaque sous-module photovoltaïque par un composant de test comprenant une cellule photovoltaïque mono-jonction.

De préférence, les lampes sont des lampes à éclat.

Selon un mode de réalisation, on utilise autant de miroirs paraboliques que de sources lumineuses, chaque source lumineuse étant agencée au foyer du miroir parabolique correspondant.

Selon une forme d'exécution particulière, on utilise autant de sources lumineuses ponctuelles et de miroirs paraboliques que de sous-modules du module photovoltaïque à tester, chaque source lumineuse et chaque miroir parabolique étant couplés de sorte à envoyer un faisceau lumineux quasi collimaté vers un sous-module correspondant.

La surface du module à tester peut être supérieure ou égale à 8 m².

Par ailleurs, les cellules du module peuvent être des cellules multi-jonctions.

Un autre objet de l'invention concerne un dispositif de test d'un module photovoltaïque à concentration comprenant une pluralité de sous-modules comprenant chacun une pluralité d'ensembles d'une cellule photovoltaïque et d'un concentrateur agencé par rapport à la cellule pour concentrer vers ladite cellule un rayonnement arrivant en incidence normale, ledit dispositif de test étant caractérisé en ce qu'il comprend :
- une pluralité de sources lumineuses, chaque source lumineuse comprenant une lampe adaptée pour émettre une impulsion lumineuse et un dispositif d'alimentation adapté pour alimenter électriquement ladite lampe, chaque source lumineuse présentant un délai d'allumage entre le déclenchement du dispositif d'alimentation et l'émission de l'impulsion par la lampe, ledit délai étant propre à chaque source lumineuse respective,
- une pluralité de miroirs paraboliques couplés aux sources lumineuses de manière à renvoyer la lumière issue de chaque source dans une pluralité de faisceaux lumineux quasi-collimatés vers le module à tester, dans une direction perpendiculaire à la surface dudit module,
- un système de synchronisation des sources lumineuses, configuré pour déclencher le dispositif d'alimentation de chaque lampe à un instant respectif déterminé en fonction du délai d'allumage de ladite lampe de sorte que les impulsions desdites lampes soient émises simultanément et reçues simultanément par les sous-modules, et
- un dispositif de mesure pour mesurer la réponse du module pendant lesdites impulsions simultanées.

### BREVE DESCRIPTION DES DESSINS

D'autres caractéristiques et avantages de l'invention ressortiront de la description détaillée qui va suivre, en référence aux dessins annexés sur lesquels :
- la figure 1A est un schéma de principe d'un module photovoltaïque à concentration comprenant plusieurs sous-modules connectés en série ;
- la figure 1B est un schéma de principe d'un ensemble cellule photovoltaïque - concentrateur appartenant à un sous-module d'un tel module ;
- la figure 2 est une vue d'ensemble d'un dispositif de test selon l'invention,
- la figure 3 illustre une impulsion lumineuse,
- la figure 4 illustre le principe de synchronisation pour trois sources lumineuses.

### DESCRIPTION DETAILLEE DE L'INVENTION

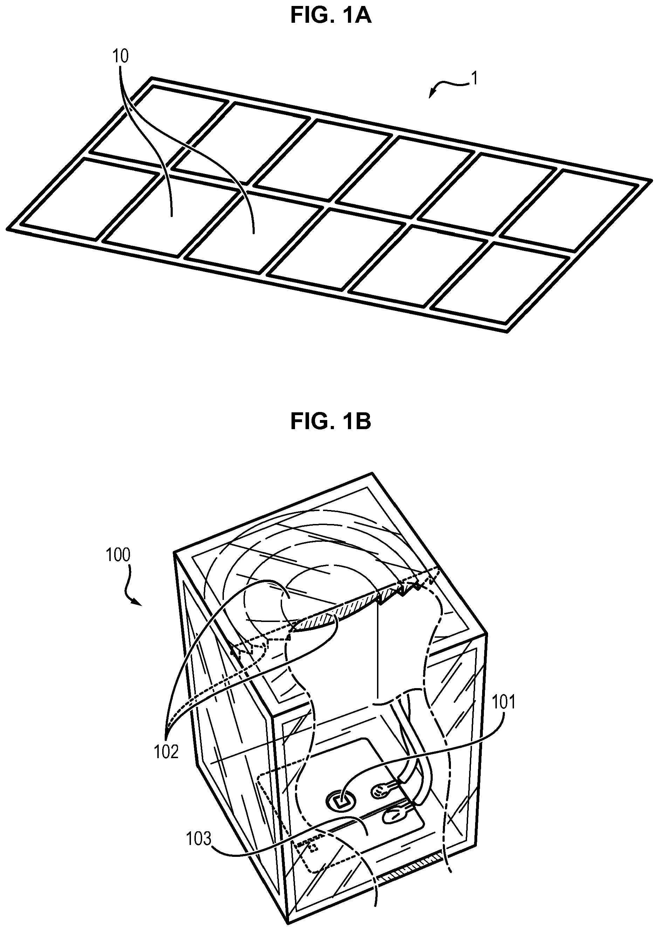

La figure 1A est un schéma de principe d'un module photovoltaïque que l'invention permet de tester.

Ledit module 1 à tester comprend une pluralité de sous-modules photovoltaïques à concentration 10.

Chaque sous-module 10 comprend une pluralité d'ensembles cellule - concentrateur.

Comme illustré sur la figure 1B, chaque ensemble 100 comprend essentiellement une cellule photovoltaïque 101 (par exemple multi-jonctions) et un concentrateur 102 destiné à concentrer vers ladite cellule 101 le rayonnement solaire arrivant en incidence normale. De manière optionnelle, la cellule 101 est placée sur un dissipateur de chaleur 103 pour limiter son élévation de température.

Le concentrateur 102 est constitué par exemple d'une lentille de Fresnel.

Dans le présent texte, la surface du module à tester est la surface des concentrateurs.

Les sous-modules 10 formant le module 1 peuvent éventuellement être électriquement connectés en série ou en parallèle.

La surface de chaque sous-module 10 présente généralement une forme rectangulaire, dont la largeur et la hauteur sont respectivement comprises dans les gammes suivantes : entre 30 et 80 cm de largeur, par exemple 60 cm, et entre 60 et 150 cm de hauteur, par exemple 120 cm.

Les sous-modules 10 sont typiquement agencés sous forme de rangées et/ou colonnes pour former le module.

Par exemple, un module de 8 m² peut être formé de deux rangées de six sous-modules, chaque sous-module présentant une surface d'environ 0,7 m².

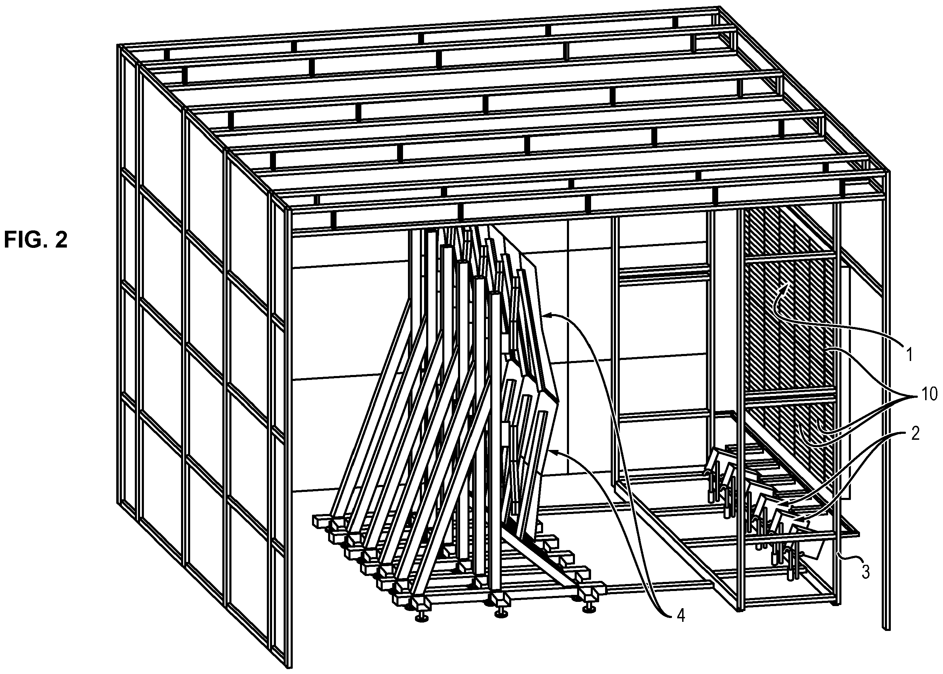

La figure 2 est une vue d'ensemble d'un dispositif de test conforme à l'invention.

Le dispositif comprend un support 3 pour le module 1 à tester.

De préférence, le support 3 est agencé de sorte que la surface du module à tester soit verticale.

Par « verticale », on entend dans le présent texte une direction perpendiculaire au plancher du bâtiment dans lequel le dispositif de test est installé.

Le module est couplé à un dispositif de mesure (non illustré) qui permet de mesurer la réponse du module à l'éclairement par un faisceau lumineux.

La mesure est effectuée pendant une durée déterminée, par exemple de l'ordre de 1 ms.

En regard du support 3, le dispositif de test comprend une pluralité de sources lumineuses 2 et une pluralité de miroirs paraboliques 4 couplés aux sources lumineuses de manière à réfléchir la lumière issue de chaque source en un faisceau lumineux quasi collimaté dans une direction perpendiculaire à la surface du module..

Selon un mode de réalisation préféré, chaque source est agencée au foyer du miroir parabolique correspondant.

Dans ce cas, le dispositif de test comprend donc autant de sources que de miroirs.

Ceci permet d'utiliser une pluralité de miroirs identiques, dont la position et l'orientation sont ajustées de sorte à renvoyer vers le module à tester un faisceau quasi collimaté perpendiculaire à la surface dudit module.

Selon un autre mode de réalisation, chaque source lumineuse peut être couplée à plusieurs miroirs, dans la mesure où ces miroirs sont agencés de sorte que leurs foyers soient confondus, la source étant agencée à l'emplacement de ces foyers.

Dans le mode de réalisation illustré sur la figure 2, où le module 1 comprend deux rangées horizontales de six sous-modules 10, le dispositif de test comprend douze sources lumineuses 2 disposées selon deux rangées horizontales de part et d'autre du module 1, et douze miroirs paraboliques 4 disposés selon deux rangées horizontales en regard du module 1.

Chaque source et le miroir parabolique correspondant sont orientés l'un par rapport à l'autre de sorte que le faisceau lumineux renvoyé par le miroir soit perpendiculaire à la surface du sous-module correspondant.

La distance entre les sources et les miroirs paraboliques est définie de sorte que le faisceau lumineux quasi collimaté renvoyé par chaque miroir éclaire avec les caractéristiques souhaitées la totalité de la surface du sous-module correspondant.

Cette distance, ainsi que la surface des miroirs, dépend donc de la surface des sous-modules du module à tester.

Sans vouloir être limitatif, on considère qu'une distance de l'ordre de 2 à 6 mètres mesurée au sol entre les miroirs paraboliques et les sources lumineuses - qui détermine la majeure partie de la surface au sol du dispositif de test - est raisonnable.

Il n'est cependant pas indispensable que le nombre de sources lumineuses et de miroirs paraboliques soit identique au nombre de sous-modules du module photovoltaïque à tester.

En effet, si la surface de chaque sous-module est suffisamment faible, on peut prévoir qu'un couple source lumineuse - miroir parabolique éclaire plusieurs sous-modules tout en conservant un encombrement au sol acceptable du dispositif de test et une taille de miroir qui ne grève pas son coût de fabrication.

D'autre part, il peut exister des zones, à la frontière entre des faisceaux quasi collimatés adjacents, dans lesquelles l'intensité ne remplit pas les critères d'uniformité ou de divergence.

Dans ce cas, on agence avantageusement les sources lumineuses et les miroirs paraboliques de sorte à ce que des zones non illuminées par les faisceaux collimatés envoyés par les miroirs coïncident avec les zones séparant les sous-modules du module à tester, qui ne sont pas fonctionnelles en termes de conversion photovoltaïque.

Pour des raisons d'assemblage des modules, il existe en effet, comme on peut le voir sur la figure 1A, un espace entre deux sous-modules 10 adjacents, au niveau desquels il ne se produit aucune conversion photovoltaïque.

Ainsi, si d'éventuels défauts d'uniformité se produisent dans ces zones, ces défauts n'ont pas d'effet négatif sur la qualité du test.

Pour permettre ce réglage, le dispositif de test est conçu de telle sorte qu'un ajustement de la position et de l'orientation de chaque miroir soit possible.

Un jeu est avantageusement prévu entre les miroirs pour permettre de tels ajustements.

Chaque source lumineuse comprend une lampe sélectionnée pour sa capacité à produire le spectre lumineux ainsi que l'irradiance voulus, et un dispositif d'alimentation adapté pour alimenter électriquement ladite lampe.

En général, ladite lampe est une lampe à éclat (aussi appelée lampe flash).

Par exemple la lampe est une lampe à éclat au xénon.

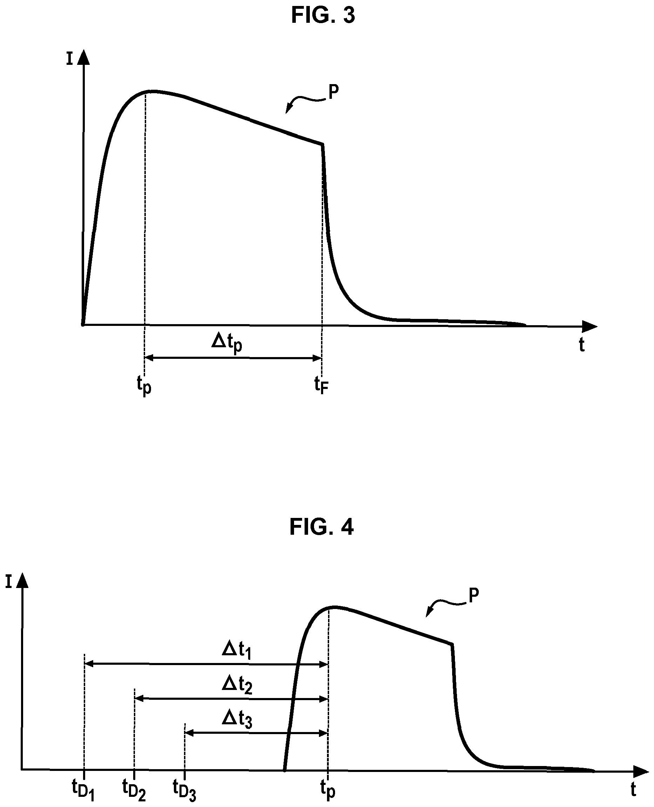

Une telle lampe adaptée émet un éclairement sous la forme d'une impulsion lumineuse P, comme illustré sur la figure 3.

Une telle impulsion est obtenue par une décharge brutale d'une batterie de condensateurs.

L'impulsion P présente donc un maximum d'intensité à un instant t_{P} considéré dans le présent texte comme étant l'instant de l'impulsion, suivi d'une décroissance lente de l'intensité jusqu'à un instant t_{F} où l'on interrompt la décharge en la mettant en court-circuit au travers d'une résistance faible de sorte à limiter l'énergie envoyée dans la lampe

En effet, la lampe ne pouvant supporter qu'une énergie assez faible, la durée de l'impulsion doit être d'autant plus courte que l'on souhaite une impulsion intense.

Afin de conserver une forme de l'impulsion relativement plate autour du maximum d'intensité (l'impulsion étant alors assimilable à un créneau), on utilise avantageusement une batterie de condensateurs surdimensionnée et l'on interrompt la décharge une fois la mesure effectuée.

Les mesures réalisées sur le module doivent être réalisées pendant l'impulsion de chaque lampe, après l'instant t_{P}.

La durée Δt_{P} de l'impulsion, correspondant à la différence entre les instants t_{F} et t_{P}, est donc définie de sorte à être au moins égale à la somme de la durée nécessaire à la mesure, du décalage temporel maximal qui peut exister entre les impulsions de deux lampes, ainsi que d'une marge de sécurité le cas échéant.

En pratique, la durée de l'impulsion est typiquement comprise entre 500 µs et 2 ms.

Selon un mode de réalisation de l'invention, la mesure est réalisée pendant une durée de 1 ms, la durée de l'impulsion de chaque lampe étant alors légèrement supérieure à cette durée.

Naturellement, il est possible d'effectuer la mesure pendant une durée plus courte, par exemple si l'on utilise une lampe produisant une intensité plus élevée, l'impulsion devant alors être plus court.

Le dispositif d'alimentation des lampes est conventionnel et ne nécessite donc pas de description détaillée, l'homme du métier pouvant choisir tout dispositif d'alimentation adéquat présent sur le marché.

En raison des composants électroniques mis en oeuvre dans le dispositif d'alimentation et de l'utilisation d'une pluralité de cartes de déclenchement comportant chacune une horloge différente, il se produit usuellement un délai d'allumage entre le déclenchement du dispositif d'alimentation et l'émission de l'impulsion par la lampe.

Pour pallier l'existence de ce délai, qui est variable d'une source à l'autre, l'invention propose un procédé de synchronisation des impulsions des différentes lampes décrit ci-après.

Dans un premier temps, on détermine pour chaque source lumineuse le délai d'allumage.

La détermination de ce délai peut être mise en oeuvre en mesurant d'une part l'instant de déclenchement de la lampe et d'autre part l'instant où le maximum d'intensité de l'impulsion se produit.

La mesure de l'instant de l'impulsion peut être obtenue en plaçant, à la place d'un sous-module, un composant de test comprenant une cellule mono-jonction par exemple.

Un tel composant produit en effet une réponse instantanée (ou en tout état de cause avec un délai de réponse négligeable au regard de celui que l'on cherche à mesurer) à une impulsion d'éclairement, de sorte qu'il est possible de mesurer directement l'instant de l'impulsion.

Le délai d'allumage est défini comme étant la différence entre l'instant de l'impulsion et l'instant de déclenchement.

On mesure ainsi le délai d'allumage pour chaque lampe, en procédant comme indiqué ci-dessus.

Une fois cette mesure effectuée, le délai d'allumage n'est pas susceptible de varier tant que chaque lampe est fonctionnelle.

On peut donc se contenter de mesurer le délai d'allumage lorsque l'on remplace une lampe sur le dispositif de test.

Le dispositif de test comprend un système de synchronisation des sources lumineuses qui comprend une mémoire dans laquelle le délai d'allumage de chaque source est enregistré.

Le système de synchronisation comprend en outre un processeur qui, lorsqu'un ordre d'enclenchement des sources est émis, détermine, pour chaque source, l'instant de déclenchement de chaque lampe comme étant égal à la différence entre un instant déterminé auquel l'impulsion synchronisée doit se produire et le délai d'allumage de chaque source.

Le système de synchronisation déclenche alors chaque source à cet instant respectif déterminé.

Ainsi, les impulsions de l'ensemble des lampes sont simultanées.

Ce principe est représenté sur la figure 4, dans le cas de trois sources lumineuses.

La figure 4 présente l'intensité lumineuse I de l'impulsion en fonction du temps t.

L'instant de l'impulsion P, qui est ici synchronisée pour les trois sources, est noté t_{P}.

La première source lumineuse présente un délai d'allumage Δt₁ et est déclenchée à un instant t_{D1} = t_{P} - Δt₁.

La deuxième source lumineuse présente un délai d'allumage Δt₂ et est déclenchée à un instant t_{D2} = t_{P} - Δt₂.

La troisième source lumineuse présente un délai d'allumage Δt₃ et est déclenchée à un instant t_{D3} = t_{P} - Δt₃.

Ainsi, chaque sous-module reçoit au même instant l'impulsion de chaque source.

## Revendications

1. Procédé de test d'un module photovoltaïque à concentration (1) comprenant une pluralité de sous-modules (10) comportant chacun une pluralité d'ensembles d'une cellule photovoltaïque (101) et d'un concentrateur (102) agencé par rapport à la cellule pour concentrer vers ladite cellule un rayonnement arrivant en incidence normale, ledit procédé comprenant les étapes suivantes:
- on envoie vers ledit module une pluralité de faisceaux lumineux quasi collimatés au moyen d'une pluralité de sources lumineuses (2) couplées à des miroirs paraboliques (4) respectifs, chaque source lumineuse (2) comprenant une lampe adaptée pour émettre une impulsion lumineuse et un dispositif d'alimentation adapté pour alimenter électriquement ladite lampe, chaque source lumineuse présentant un délai d'allumage entre le déclenchement du dispositif d'alimentation et l'émission de l'impulsion par la lampe, ledit délai étant propre à chaque source lumineuse respective,
- on déclenche le dispositif d'alimentation de chaque lampe à un instant respectif déterminé en fonction du délai d'allumage de ladite lampe de sorte que les impulsions de l'ensemble des lampes soient émises simultanément et reçues simultanément par les sous-modules, et
- on mesure la réponse du module pendant lesdites impulsions simultanées.

2. Procédé selon la revendication 1, **caractérisé en ce que** l'on détermine au préalable le délai d'allumage de chaque lampe en mesurant l'instant de déclenchement du dispositif d'alimentation et l'instant de l'impulsion, le délai d'allumage étant déterminé comme étant égal à la différence entre l'instant de l'impulsion et l'instant de déclenchement.

3. Procédé selon la revendication 2, **caractérisé en ce que** lesdites mesures du délai d'allumage sont effectuées en remplaçant chaque sous-module photovoltaïque par un composant de test comprenant une cellule photovoltaïque mono-jonction.

4. Procédé selon l'une des revendications 1 à 3, **caractérisé en ce que** les lampes sont des lampes à éclat.

5. Procédé selon l'une des revendications 1 à 4, **caractérisé en ce que** l'on utilise autant de miroirs paraboliques que de sources lumineuses, chaque source lumineuse étant agencée au foyer du miroir parabolique correspondant.

6. Procédé selon la revendication 5, **caractérisé en ce que** l'on utilise autant de sources lumineuses ponctuelles et de miroirs paraboliques que de sous-modules du module photovoltaïque à tester, chaque source lumineuse (2) et chaque miroir parabolique (4) étant couplés de sorte à envoyer un faisceau lumineux quasi collimaté vers un sous-module correspondant.

7. Procédé selon l'une des revendications 1 à 6, **caractérisé en ce que** la surface du module à tester est supérieure ou égale à 8 m².

8. Procédé selon l'une des revendications 1 à 7, **caractérisé en ce que** les cellules du module sont des cellules multi-jonctions.

9. Dispositif de test d'un module photovoltaïque à concentration (1) comprenant une pluralité de sous-modules (10) comprenant chacun une pluralité d'ensembles d'une cellule photovoltaïque (101) et d'un concentrateur (102) agencé par rapport à la cellule pour concentrer vers ladite cellule un rayonnement arrivant en incidence normale, ledit dispositif de test étant **caractérisé en ce qu'**il comprend :
- une pluralité de sources lumineuses (2), chaque source lumineuse comprenant une lampe adaptée pour émettre une impulsion lumineuse et un dispositif d'alimentation adapté pour alimenter électriquement ladite lampe, chaque source lumineuse présentant un délai d'allumage entre le déclenchement du dispositif d'alimentation et l'émission de l'impulsion par la lampe, ledit délai d'allumage étant propre à chaque source lumineuse respective,
- une pluralité de miroirs paraboliques (4) couplés aux sources lumineuses (2) de manière à renvoyer la lumière issue de chaque source (2) dans une pluralité de faisceaux lumineux quasi-collimatés vers le module (1) à tester, dans une direction perpendiculaire à la surface dudit module (1),
- un système de synchronisation des sources lumineuses (2), configuré pour déclencher le dispositif d'alimentation de chaque lampe à un instant respectif déterminé en fonction du délai d'allumage de ladite lampe de sorte que les impulsions desdites lampes soient émises simultanément et reçues simultanément par les sous-modules, et
- un dispositif de mesure pour mesurer la réponse du module pendant lesdites impulsions simultanées.

## Patentansprüche

1. Verfahren zum Testen eines konzentrierten photovoltaischen Moduls (1), umfassend mehrere Untermodule (10), die jeweils eine Mehrzahl von Einheiten einer photovoltaischen Zelle (101) und eines Konzentrators (102) aufweisen, die bezogen auf die Zelle angeordnet ist, um eine Strahlung, die mit einem normalen Einfallswinkel eintrifft, in Richtung der Zelle zu konzentrieren, wobei das Verfahren die folgenden Schritte umfasst:
- Senden einer Mehrzahl von nahezu kollimatierten Lichtstrahlen in Richtung des Moduls mittels einer Mehrzahl von Lichtquellen (2), die an jeweilige Parabolspiegel (4) gekoppelt sind, wobei jede Lichtquelle (2) eine Lampe, die angepasst ist, einen Lichtimpuls abzugeben, und eine Versorgungsvorrichtung, die angepasst ist, die Lampe elektrisch zu versorgen, umfasst, wobei jede Lichtquelle eine Zündverzögerung zwischen der Auslösung der Versorgungsvorrichtung und der Abgabe des Impulses durch die Lampe aufweist, wobei die Verzögerung für jede jeweilige Lichtquelle individuell ist,
- Auslösen der Versorgungsvorrichtung jeder Lampe zu einem jeweiligen Zeitpunkt, der je nach der Zündverzögerung der Lampe bestimmt wird, damit die Impulse aller Lampen gleichzeitig abgegeben und gleichzeitig von den Untermodulen empfangen werden, und
- Messen des Ansprechens des Moduls während der gleichzeitigen Impulse.

2. Verfahren nach Anspruch 1, **dadurch gekennzeichnet, dass** zuvor durch Messen des Auslösezeitpunkts der Versorgungsvorrichtung und des Impulszeitpunkts die Zündverzögerung jeder Lampe bestimmt wird, wobei die Zündverzögerung so bestimmt wird, dass sie gleich der Differenz zwischen dem Impulszeitpunkt und dem Auslösezeitpunkt ist.

3. Verfahren nach Anspruch 2, **dadurch gekennzeichnet, dass** die Messungen der Zündverzögerung durch Ersetzen jedes photovoltaischen Untermoduls durch eine Testkomponente, die eine Einfachübergang-Photovoltaikzelle umfasst, durchgeführt werden.

4. Verfahren nach einem der Ansprüche 1 bis 3, **dadurch gekennzeichnet, dass** die Lampen Blitzlampen sind.

5. Verfahren nach einem der Ansprüche 1 bis 4, **dadurch gekennzeichnet, dass** genauso viele Parabolspiegel wie Lichtquellen genutzt werden, wobei jede Lichtquelle im Brennpunkt des entsprechenden Parabolspiegels angeordnet ist.

6. Verfahren nach Anspruch 5, **dadurch gekennzeichnet, dass** genauso viele Punktlichtquellen und Parabolspiegel wie Untermodule des zu testenden Photovoltaikmoduls genutzt werden, wobei jede Lichtquelle (2) und jeder Parabolspiegel (4) gekoppelt sind, um einen nahezu kollimatierten Lichtstrahl in Richtung eines entsprechenden Untermoduls zu senden.

7. Verfahren nach einem der Ansprüche 1 bis 6, **dadurch gekennzeichnet, dass** die Fläche des zu testenden Moduls größer oder gleich 8 m² ist.

8. Verfahren nach einem der Ansprüche 1 bis 7, **dadurch gekennzeichnet, dass** die Zellen des Moduls Mehrfachübergang-Zellen sind.

9. Vorrichtung zum Testen eines konzentrierten photovoltaischen Moduls (1), das einer Mehrzahl von Untermodulen (10) umfasst, die jeweils eine Mehrzahl von Einheiten einer photovoltaischen Zelle (101) und eines Konzentrators (102) aufweisen, die bezogen auf die Zelle angeordnet ist, um eine Strahlung, die mit einem normalen Einfallswinkel eintrifft, hin zu der Zelle zu konzentrieren, wobei die Vorrichtung zum Testen **dadurch gekennzeichnet ist, dass** sie umfasst:
- eine Mehrzahl von Lichtquellen (2), wobei jede Lichtquelle eine Lampe, die angepasst ist, einen Lichtimpuls abzugeben, und eine Versorgungsvorrichtung, die angepasst ist, die Lampe elektrisch zu versorgen, umfasst, wobei jede Lichtquelle eine Zündverzögerung zwischen der Auslösung der Versorgungsvorrichtung und der Abgabe des Impulses durch die Lampe aufweist, wobei die Zündverzögerung für jede jeweilige Lichtquelle individuell ist,
- eine Mehrzahl von Parabolspiegeln (4), die an die Lichtquellen (2) gekoppelt sind, um das Licht, das aus jeder Quelle (2) kommt, in einer Mehrzahl von nahezu kollimatierten Lichtstrahlen hin zu dem zu testenden Modul (1) in einer Richtung zurückzuwerfen, die senkrecht zu der Fläche des Moduls (1) ist,
- ein System zum Synchronisieren der Lichtquellen (2), das ausgelegt ist, die Versorgungsvorrichtung jeder Lampe zu einem jeweiligen Zeitpunkt auszulösen, der je nach der Zündverzögerung der Lampe bestimmt wird, damit die Impulse der Lampen gleichzeitig abgegeben und gleichzeitig von den Untermodulen empfangen werden, und
- eine Vorrichtung zum Messen, um das Ansprechen des Moduls während der gleichzeitigen Impulse zu messen.

## Claims

1. Method for testing a concentrating photovoltaic module (1) comprising a plurality of submodules (10) each including a plurality of assemblies of a photovoltaic cell (101) and of a concentrator (102) that is arranged with respect to the cell to concentrate onto said cell radiation arriving at normal incidence, said method comprising the following steps:
- a plurality of almost collimated light beams are sent towards said module by means of a plurality of light sources (2) that are coupled to respective parabolic mirrors (4), each light source (2) comprising a lamp suitable for emitting a light pulse and a power supply suitable for supplying said lamp with electrical power, each light source exhibiting a turn-on delay between the triggering of the power supply and the emission of the pulse by the lamp, said delay being specific to each respective light source;
- the power supply of each lamp is triggered at a respective instant determined depending on the turn-on delay of said lamp so that the pulses of all of the lamps are emitted simultaneously and received simultaneously by the submodules; and
- the response of the module is measured during said simultaneous pulses.

2. Method according to Claim 1, **characterized in that** the turn-on delay of each lamp is determined beforehand by measuring the triggering instant of the power supply and the instant of the pulse, the turn-on delay being defined as being equal to the difference between the instant of the pulse and the triggering instant.

3. Method according to Claim 2, **characterized in that** said measurements of turn-on delay are carried out by replacing each photovoltaic submodule with a test component comprising a single-junction photovoltaic cell.

4. Method according to one of Claims 1 to 3, **characterized in that** the lamps are flashlamps.

5. Method according to one of Claims 1 to 4, **characterized in that** as many parabolic mirrors are used as there are light sources, each light source being arranged at the focal point of the corresponding parabolic mirror.

6. Method according to Claim 5, **characterized in that** as many point light sources and parabolic mirrors are used as there are submodules of the photovoltaic module to be tested, each light source (2) and each parabolic mirror (4) being coupled so as to send an almost collimated light beam towards a corresponding submodule.

7. Method according to one of Claims 1 to 6, **characterized in that** the area of the module to be tested is larger than or equal to 8 m².

8. Method according to one of Claims 1 to 7, **characterized in that** the cells of the module are multi-junction cells.

9. Device for testing a concentrating photovoltaic module (1) comprising a plurality of submodules (10) each comprising a plurality of assemblies of a photovoltaic cell (101) and of a concentrator (102) that is arranged with respect to the cell to concentrate onto said cell radiation arriving at normal incidence, said testing device being **characterized in that** it comprises:
- a plurality of light sources (2), each light source comprising a lamp suitable for emitting a light pulse and a power supply suitable for supplying said lamp with electrical power, each light source exhibiting a turn-on delay between the triggering of the power supply and the emission of the pulse by the lamp, said turn-on delay being specific to each respective light source;
- a plurality of parabolic mirrors (4) that are coupled to the light sources (2) so as to redirect the light generated by each light source (2) in a plurality of almost collimated light beams towards the module (1) to be tested, in a direction that is perpendicular to the surface of said module (1);
- a system for synchronizing the light sources (2), which system is configured to trigger the power supply of each lamp at a respective instant defined depending on the turn-on delay of said lamp so that the pulses of said lamps are emitted simultaneously and received simultaneously by the submodules; and
- a measuring device for measuring the response of the module during said simultaneous pulses.
